(19) **Europäisches Patentamt**
**European Patent Office**
**Office européen des brevets**

(11) **EP 2 772 328 B1**

(12) **EUROPEAN PATENT SPECIFICATION**

(45) Date of publication and mention
of the grant of the patent:
**03.07.2019 Bulletin 2019/27**

(21) Application number: **12843695.3**

(22) Date of filing: **09.10.2012**

(51) Int Cl.:
*B22F 1/02* (2006.01)          *B22F 1/00* (2006.01)
*H05K 1/14* (2006.01)          *B82Y 30/00* (2011.01)
*C09J 11/04* (2006.01)         *H01L 23/00* (2006.01)
*C08K 3/08* (2006.01)          *C08K 9/04* (2006.01)

(86) International application number:
**PCT/JP2012/006468**

(87) International publication number:
**WO 2013/061527 (02.05.2013 Gazette 2013/18)**

(54) **COMPOSITION FOR BONDING**

ZUSAMMENSETZUNG ZUM BONDEN

COMPOSITION POUR COLLAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.10.2011  JP 2011232714**

(43) Date of publication of application:
**03.09.2014  Bulletin 2014/36**

(73) Proprietor: **Bando Chemical Industries, Ltd.
Kobe-shi, Hyogo 650-0047 (JP)**

(72) Inventors:
• **TAKESUE, Masafumi**
**Kobe-shi, Hyogo 6500047 (JP)**

• **YAMADA , Mitsuru,**
**Kobe-shi, Hyogo 6500047 (JP)**
• **SHIMOYAMA ,Kenji**
**Kobe-shi, Hyogo  6500047 (JP)**
• **WATANABE,Tomofumi**
**Kobe-shi, Hyogo 6500047 (JP)**

(74) Representative: **Mewburn Ellis LLP
City Tower
40 Basinghall Street
London EC2V 5DE (GB)**

(56) References cited:
**WO-A1-2004/108345     JP-A- 2008 178 911
JP-A- 2010 050 189     JP-A- 2010 265 543
JP-A- 2011 095 244**

EP 2 772 328 B1

## Description

### Technical Field

The present invention relates to a composition for bonding containing inorganic particles, and an organic substance containing amine and carboxylic acid adhered at least onto a portion of surfaces of inorganic particles.

### Background Technology

In order to mechanically and/or electrically and/or thermally bond a metal component and another metal component, conventionally, solder, a conductive adhesive, silver paste, anisotropically-conductive film and the like are used. These conductive adhesive, silver paste, anisotropically-conductive film and the like are sometimes used when not only metal components but a ceramic component, a resin component and the like are bonded. For example, bonding of a light-emitting element, such as LED, to a substrate, bonding of a semiconductor chip to a substrate, and further bonding of these substrates to a radiation member can be exemplified.

Among them, an adhesive containing a conductive filler made of solder and metal, paste and a film are used for bonding at a portion requiring an electric connection. In addition, since metal generally has high thermal conductivity, these adhesive containing solder and conductive filler, paste and film may be used for increasing heat dissipation.

In the meantime, for example, when an illumination device or a light-emitting device with high luminance is produced using a light-emitting element, such as LED, or when a semiconductor device is produced using a semiconductor element that is referred to as a power device, and that performs highly efficient at high temperature, a calorific value tends to increase. Although an efficiency of a device or an element is attempted to be improved for reducing heat generation, a sufficient result has not been achieved in the current situation, and operating temperature of a device or an element is increased.

Further, from a viewpoint to prevent damaging a device upon bonding, a bonding material that can ensure sufficient strength at low bonding temperature (for example, at 300 °C or lower) is in demand. Therefore, in a bonding material for bonding a device, an element or the like, reduction in bonding temperature, and, thermal resistance that tolerates an increase of operating temperature by the performance of the device after bonding and can maintain sufficient bonding strength are in demand, but conventional bonding materials cannot often sufficiently respond to this demand. For example, solder bonds members via a process to heat metal at its melting point or higher (re-flow process), but since the melting point is unique to the composition in general, if the heat proof temperature is attempted to be increased, the heating (bonding) temperature is also increased.

In addition, when an element(s) and a substrate(s) are bonded by overlapping several layers, it is necessary to be via a heating process by an increment of layers to be overlapped, and in order to prevent melting at an already-bonded portion, it is necessary to increase a melting point (bonding temperature) of solder that is used for next bonding, and types of chemical composition of solder are required by an increment of layers to be overlapped, and handling becomes complicated.

On the other hand, in the conductive adhesive, the silver paste and the anisotropically-conductive film, members are bonded by utilizing thermal curing of contained epoxy resin and the like, but if the operating temperature of the obtained device or element is increased, the resin ingredient may be decomposed or deteriorated. For example, in Patent Literature 1 (Japanese Patent Laid-Open No. 2008-63688), microparticles that are designed to obtain higher bonding strength when members to be bonded are joined using a primary material of the bonding material are proposed, but the problems of decomposition and deterioration of resin components upon increase of operating temperature have not been eliminated.

### PRIOR ART LITERATURE

#### Patent Literature

Patent Literature 1: Japanese Patent Laid-Open Application 2008-63688 JP 2011-95244 A proposes organic matter coated metal particles.

### SUMMARY OF INVENTION

#### Problem to be Solved by the Invention

In light of the circumstances above, the objective of the present invention is to provide a composition for bonding that can obtain high bonding strength by bonding at comparatively low temperature, and, that is equipped with thermal resistance where it is difficult to cause reduction in bonding strength due to decomposition or deterioration of a resin ingredient upon increase of operating temperature, and particularly to provide a composition for bonding containing metallic particles.

**Means for Solving the Problem**

The inventors of the present invention, as a result of keen study about composition of a composition for bonding and a weight reduction rate upon heating in order to accomplish the objective, discovered that it is extremely effective to accomplish the objective by using inorganic particles and an organic substance containing amine(s) and carboxylic acid(s) adhered onto at least a portion of surfaces of the inorganic particles, and, by adjusting the weight reduction rate upon heating in a specific temperature range to a certain range, and accomplished the present invention.
In other words, the present invention provides a composition for bonding according to claim 1.
The composition for bonding of the present invention is characterized such that the weight reduction rate upon heating from room temperature to 200 °C is 33 % to 69 % according to thermal analysis, and, a weight reduction rate is 24 % to 50 % upon heating from 200 °C to 300 °C, and the inventors of the present application discovered that superior bonding strength is developed due to these characteristics. It is inferred that this is because of the balance between the volatilization of an organic substance and fusion of inorganic particles is excellent in the composition for bonding upon heating.
For example, a case when the composition for bonding of the present invention is applied onto an alumina ceramics substrate having a surface with a gold finish, and the same substrate is mounted from the above and the obtained laminated body is heated at 300 °C. When the temperature of the composition for bonding is gradually increased due to heating, because the weight reduction rate upon heating from room temperature to 200 °C is 33 % to 69 %, an organic ingredient, comparatively easily volatilizes up to reaching 200 °C, volatilizes. In this stage, a considerable amount of the organic substance still remains, and the inorganic particles are not still aggressively fused with each other, and the composition for bonding in the applied state still has flexibility. Consequently, even if an organic substance becomes gas and volatilizes and a void-like portion (passage) is produced after the gas passes through, the surrounding composition for bonding moves and the portion is buried. Then, a connection of the fused inorganic particles becomes integral, and sufficient bonding strength is obtained; therefore, conductivity and thermal conductivity are also improved.
Furthermore, when bonding is actually implemented using the composition for bonding of the present invention, an organic substance may be decreased without increasing the temperature to be a standard (200 °C or 300 °C) in the thermal analysis defined in the present invention, but a decrease behavior of the organic substance upon bonding in association with the temperature increase according to the thermal analysis can be analyzed in detail, and this enables clear definition of properties of the composition for bonding of the present invention upon heating (bonding).
In the composition for bonding of the present invention, because the weight reduction rate upon heating from 200 °C to 300 °C is small at 24 % to 50 %, an amount of organic substance to be evaporated as gas, on the occasion when temperature becomes high due to the heating as mentioned above and fusion of the inorganic particles becomes active, is small, and it is difficult for integrity of connection of fused inorganic particles to be impaired and sufficient bonding strength is obtained; therefore, the conductivity and the thermal conductivity are also improved.
In addition, in the composition for bonding of the present invention, an amino group and a carboxyl group within one molecule of amine and carboxylic acid indicate comparatively high polarity, respectively, and interaction due to hydrogen bond is easily generated, but a portion other than these functional group have comparatively low polarity. In addition, an amino group and a carboxyl group easily indicate alkaline and acidic properties.
Therefore, amine and carboxylic acid are localized (adhered) at least onto surfaces of the inorganic particles in the composition for bonding of the present invention (i.e., cover at least a portion of the surfaces of the inorganic particles), the organic substance and the inorganic particles can sufficiently be affinitized, and agglomeration of the inorganic particles is prevented. Further, even in the case of adding a dispersion medium as the occasion arises, because the organic substance acts as a dispersant, a dispersion state of the inorganic particles in the dispersion medium is remarkably improved. In other words, according to the composition for bonding of the present invention, since an organic substance with a specific combination is contained, it is difficult that inorganic particles agglutinate and dispersibility of the inorganic particles is excellent even in a coating film, and are uniformly fused and a strong bonding strength is obtained.
Herein, the composition for bonding of the present invention, in other words, is a composition that consists primarily of colloidal particles made from inorganic particles and an organic substance, and may be a colloidal dispersion liquid further containing a dispersion medium. "Dispersion medium" is to disperse the colloidal particles into a dispersion liquid, but a portion of structural components of the colloidal particles may be dissolved into "dispersion medium". Furthermore, "primary component" is a component with the greatest content out of the structural components.
Further, in the composition for bonding of the present invention, the inorganic particles are preferably at least one type of metallic particles out of gold, silver, copper, nickel, bismuth, tin and platinum group elements. If the composition for bonding with such configuration is used, superior bonding strength and thermal resistance can be obtained.

In addition, the composition for bonding of the present invention is preferably used for bonding of metals.

**Effect of the Invention**

According to the present invention, a composition for bonding containing inorganic particles and an organic substance containing amine(s) and carboxylic acid(s) adhered onto at least a portion of surfaces of the inorganic particles, wherein high bonding strength can be obtained even at low bonding temperature by adopting a certain composition and by optimizing a weight reduction rate in a certain temperature region.

**Mode for Carrying Out the Invention**

Hereafter, one preferred embodiment of the composition for bonding containing metallic colloid, as one preferred embodiment of the composition for bonding of the present invention, will be described in detail. Furthermore, the description below merely indicates one embodiment of the present invention, and the present invention shall not be limited to these, and redundant descriptions may be omitted.

(1) Composition for bonding

A composition for bonding containing metallic colloid in the present invention is characterized such that metallic particles and
an organic substance containing amine(s) and carboxylic acid(s) adhered onto at least a portion of surfaces of the metallic particles are contained; and
a weight reduction rate is 33 % to 69 % upon heating from room temperature to 200 °C according to thermal analysis, and, the weight reduction rate is 24 % to 50 % upon heating from 200 °C to 300 °C.

Herein, 33 % to 69 % of weight reduction rate upon heating from room temperature to 200 °C according to thermal analysis means that weight reduction Y upon heating from room temperature to 200 °C occupies 33 % to 69 % (Y = 0.33X to 0.69X) out of weight reduction X upon heating from room temperature to 500 °C, and the meaning where the weight reduction rate is 24 % to 50 % upon heating from 200 °C to 300 °C is also similar.

In the composition for bonding of the present invention having such configuration, it is characterized such that the weight reduction rate upon heating from room temperature to 200 °C according to the thermal analysis is 33 % to 69 %, and, the weight reduction rate upon heating from 200 °C to 300 °C is 24 % to 50 %, and superior bonding strength is developed due to these characteristics. It is inferred that this is because of well balance between the volatilization of an organic substance and fusion of inorganic particles in the composition for bonding upon heating.

For example, a case when the composition for bonding of the present embodiment is applied onto, for example, an alumina ceramics substrate having a surface with a gold finish, and the same substrate is mounted from the above and the obtained laminate is heated at 270 °C is assumed. On the occasion when the temperature of the composition for bonding is gradually increased due to heating, because the weight reduction rate upon heating from room temperature to 200 °C is 33 % to 69 %, an organic substance, which comparatively easily volatilizes by the time to reach 200 °C, volatilizes. In this stage, a considerable amount of organic substance still remains; metal particles are not aggressively fused with each other; and the composition for bonding in the applied condition still has flexibility. Consequently, even if an organic substance becomes gas and volatilizes and a void-like portion (passage) is produced after the gas passes through, the surrounding composition for bonding moves and the portion is buried. Then, a connection of the fused inorganic particles becomes integral, and sufficient bonding strength is obtained; therefore, conductivity and thermal conductivity are also improved.

In the composition for bonding of the present embodiment, since the weight reduction rate upon heating from 200 °C to 300 °C is within the range of 24 % to 50 %, an amount of an organic substance to be evaporated as gas on the occasion, when temperature becomes high due to heating and fusion of the metallic particles becomes active, is comparatively small and it is difficult for the integrity of the connection of the fused metallic particles to be impaired, thus sufficient bonding strength is obtained; therefore, conductivity and thermal conductivity are also improved.

If the weight reduction rate upon heating from 200 °C to 300 °C is greater than the range above, when the temperature becomes higher and the fusion of the metallic particles becomes active, because the organic substance is evaporated as gas at once, the connection of the fuse metallic particle becomes sparse. Inversely, if the weight reduction rate upon heating from 200 °C to 300 °C is smaller than the range above, the remaining organic substance is increased, and, since fusion of the metallic particles is inhibited, sufficient bonding strength can no longer be obtained.

Furthermore, as the method for adjusting the amount of organic substance within a predetermined range, as described below, adjustment by heating is simpler. The amount of the organic substance to be added on the occasion of producing metallic particles can be adjusted. Cleaning conditions and the number of times after the metallic particle adjustment may be changed. Heating can be conducted with an oven or an evaporator, and it can be conducted under reduced pressure. In the case of conducting under ordinary pressure, the heating can be conducted even in the atmosphere or in the inert atmosphere. In addition, for minute adjustment of an organic quantity, amine or carboxylic acid can be added later.

The composition for bonding of the present embodiment mainly contains metallic colloid particles where metallic particles become colloid as a primary component, but regarding a morphology of such metallic colloid particles, for example, metallic colloid particles configured by adhering an organic substance onto a portion of surfaces of metallic particles, metallic colloid particles where their surfaces are coated with an organic substance using the metallic particles as a core, metallic colloid particles that are configured by mixing these and the like can be exemplified, but it is not particularly limited. Among them, the metallic colloid particles where their surfaces are coated with an organic substance using the metallic particles as a core are preferable. One skilled in the art can arbitrarily prepare metallic colloid particles having the morphology using a known technology in the field.

The composition for bonding of the present embodiment is a fluent material that consists primarily of colloid particles made from metallic particles and an organic substance, and other than the metallic particles and an organic substance constituting metallic particles, the composition for bonding may contain an organic substance that does not consist of metallic colloid particles, a dispersion medium, a residual reducing agent or the like.

The viscosity of the composition for bonding of the present embodiment should be arbitrarily adjusted within a range not impairing the effects of the present invention, and for example, it should be within the viscosity range of 0.01 to 5000 Pa·S, and the viscosity range of 0.1 to 1,000 Pa·S is more preferable, and the viscosity range of 1 to 100 Pa·S is particularly preferable. The adjustment within the viscosity ranges above enables the application of a broad method as a method for applying a composition for bonding onto a substrate.

As a method for applying the composition for bonding onto a substrate, any method can be arbitrarily selected and adopted, for example, from dipping, screen printing, a spray technique, a barcode technique, a spin-coating technique, an inkjet technique, a dispenser technique, an application technique by a brush, a casting technique, a flexo technique, a gravure technique, an offset method, a transfer method, a hydrophilic/hydrophobic method and a syringe technique.

The viscosity can be adjusted by adjustment of particle size of metallic particles, adjustment of content of an organic substance, adjustment of additive amounts of a dispersion medium and other components, adjustment of a blending ratio of each component, addition of thickener and the like. The viscosity of the composition for bonding of the present embodiment is measured with a cone-plate viscometer (for example, Leometer MCR301 manufactured by AntonPaar). Measurement was conducted at 25 °C of temperature, and the viscosity at 50 rpm of cone rotation speed was adopted.

Next, each component of the composition for bonding of the present embodiment is described.

(1-1) About metallic particles

Although the metallic particles of the composition for bonding of the present embodiment are not particularly limited, since conductivity of an adhesion layer obtained by using the composition for bonding of the present embodiment can be improved and stabilized, it is preferable to be metal where ionization tendency is smaller (nobler) than zinc.

As such metal, for example, out of gold, silver, copper, nickel, bismuth, tin, iron and platinum group elements, one type is exemplified. As the metal, at least one type of metallic particles selected from a group constituting gold, silver, copper, nickel, bismuth, tin and platinum group nickel is preferable, and in addition, copper or at least one type of metal where its ionization tendency is smaller (nobler), i.e., gold, platinum, silver and copper is preferable. These metals may be used singularly or used as a combination of two types of more, and as a method for combination, there is a case of using alloy particles containing a plurality of metals and another case of using metallic particles having a core-shell structure or a multilayer structure.

For example, when silver particles are used for metallic particles of the composition for bonding, electroconductivity of the adhered layer formed by using the composition for bonding of the present embodiment becomes excellent, but in light of the problem of migration, it can become difficult for the migration to occur by using the composition for bonding made of silver and other metals. As "other metals", metals where its ionization series above is nobler than hydrogen, i.e., gold, copper, platinum and platinum group elements, such as palladium, are preferable.

The mean particle size (crystallite diameter) of the metallic particle (or metallic colloid particles) in the composition for bonding of the present embodiment is not particularly limited as long within the range that does not impair the effect of the present invention, but it is preferable to have mean particle size so as to cause melting point depression, and for example, this should be 2 nm to 100 nm. In addition, it should be 1 nm to 200 nm. If the mean particle size of the metallic particle is 1 nm or over, a composition for bonding that can form an excellent adhesive layer is obtained, and the metallic particle manufacturing will not cause increase in cost, and it is practical. Further, if it is 200 nm or less, it is difficult for dispersibility of metallic particles to change with time, and it is preferable.

In addition, crystallite diameter of the metallic particles (or metallic colloid particles) in the composition for bonding of the present embodiment is preferably 4 nm to 40 nm from a viewpoint to obtain solid bonding strength. For example, in Japanese Patent Laid-Open Application 2006-049196 and International Publication WO2011/007402, regarding silver particles (metallic particles) with the level of 10 nm to 30 nm of crystallite diameter, it is believed to be described that the greater the crystal particle size becomes, the more easily the metallic particles are fused, but the inventors of the present application discovered from experiments that the smaller the crystallite diameter becomes, the more preferable it is to obtain the bonding strength. It is inferred that this is attributable to amine that fulfills a function as a dispersant being solidly adsorbed and arranged around the periphery of the surface of the metallic particles.

The crystallite diameter of the metallic particles (or metallic colloid particles) in the composition for bonding of the present embodiment is, from a viewpoint to obtain solid bonding strength, is particularly preferably 13 nm to 36 nm. It is inferred that this is because mechanism where amine that fulfills the function as a dispersant is adsorbed onto the periphery of the surface of metallic particles relates to the crystal particle size.

Furthermore, it is also possible to add in conjunction with metallic particles with size of micron meters if necessary. In such case, they can be bonded by depression of the melting point of the metallic particles with size of nano meters around the metallic particles with size of micron meters

The inventors of the present application discovered that, in the composition for bonding containing an organic substance containing amine(s) and carboxylic acid(s) adhered at least onto surfaces of the metallic particles, especially using the metallic particles with smaller particle size where depression of the melting point, the bonding strength is increased by optimizing the weight reduction rate upon heating within a certain temperature range, compared to a bonding material without optimization. When the metallic particles are fused by utilizing the depression of the melting point of the metallic particles, since a capability of the depression of the melting point is eliminated after the fusion, they will not be melted until reaching a melting point of original metal. Consequently, unlike solder, heatproof temperature, which is further higher than heating temperature required for bonding, can be obtained. In addition, a concern of reduction in thermal resistance due to deterioration of an organic substance can be lessened.

Furthermore, particle size of the metallic particles in the composition for bonding of the present embodiment is not always consistent. Further, when the composition for bonding contains a dispersion medium, a resin component, an organic solvent, a thickener, a surface tension adjuster or the like as an optical component, there is a case where the mean particle size contains a metallic colloid particle component exceeding 200 nm of mean particle size, but a particle component having such mean particle size exceeding 200 nm as long as not causing agglomeration, and not remarkably impairing the effect of the present invention may also be contained.

Herein, particle size (crystallite diameter) of the metallic particles in the composition for bonding (metallic colloid dispersion liquid) can be measured with a dynamic light scattering method, a small-angle X-ray scattering technique or a wide-angle X-ray diffraction technique. In order to show depression of the melting point of the metallic particles with nano size, crystallite diameter obtained with the X-ray diffraction technique is appropriate. For example, in the wide-angle X-ray diffraction technique, to be more specific, the particle size can be measured within the range where $2\theta$ is 30 ° to 80 ° with a diffraction technique using RINT-Ultima III manufactured by Rigaku Corporation. In this case, samples should be measured by thinning so as to be a flat surface on a glass plate with approximately 0.1 mm to 1 mm of depth of depression in the center portion. Further, the crystallite diameter (D) calculated by substituting a half bandwidth of obtained diffraction spectrum using JADE manufactured by Rigaku Corporation into Scherrer equation should be regarded as particle size.

$$D = K\lambda/B \cos\theta$$

Herein, K: Scherrer constant (0.9), $\lambda$: wavelength of X-ray, B: half bandwidth of diffraction line, 0: Bragg angle.

(1-2) Organic substance adhered at least onto surfaces of metallic particles

In the composition for bonding of the present embodiment, an organic substance adhered at least onto a portion of surfaces of metallic particles, i.e., "organic substance" in metallic colloid particles substantially constitutes metallic colloid particles along with the metallic particles as a so-called dispersant. It is a concept that the organic substance does not include an organic substance where its trace amount is adhered onto metallic particles and the like, such as a trace of an organic substance contained in metal initially as an impurity, a trace of an organic substance where it is mixed during a manufacturing process and is adhered onto a metallic component, a residual reducing agent or residual dispersant that could not be removed during the cleaning process. Furthermore, "trace amount" above specifically indicates less than 1 % by mass in metallic colloid particles.

The organic substance is an organic substance where agglomeration of the metallic particles is prevented by coating the metallic particles, and, that can form the metallic colloid particles, and the morphology of coating is not particularly defined, but in the present embodiment, an organic substance containing amine(s) and carboxylic acid(s) is used from viewpoints of dispersibility and conductivity. Furthermore, in the case of chemically or physically bonding with the metallic particles, it is also believed that these organic substances are changed to anion or cation, and in the present embodiment, ions, complexes derived from these organic substance and the like are contained in the organic substances.

As amine, monoamine and polyamine are exemplified.

As the monoamine, alkylamine (straight-chain alkylamine with approximately $C_{2-20}$, may have a side chain), such as oleylamine, hexylamine, butylamine, pentylamine, hexylamine, octylamine or dodecylamine; cycloalkylamine, such as cyclopentylamine or cyclohexylamine; primary amine, such as allylamine, such as aniline; secondary amine, such as dipropylamine, dibutylamine, piperidine or hexamethyleneimine; and tertiary amine, such as tripropylamine, dimethylpropanediamine, cyclohexyldimethylamine, pyridine or quinoline, are exemplified.

As polyamine, polyamine corresponding to monoamine, for example, polyamine corresponding to ethylenediamine, tetramethylethylenediamin, triethylenetetramine, piperazine and pyrimidine is exemplified.

The amine may be a compound containing a functional group other than amine, such as a hydroxyl group, a carboxyl group, an alkoxy group, a carbonyl group, an ester group or a mercapto group. In this case, it is preferable that the number of nitrogen atoms derived from amine is greater than the number of functional groups other than amine. Further, amine may be used singularly, and may be used as a combination of two types or more. In addition, a boiling point at room temperature is preferably 300 °C or less, and is further preferably 250 °C or less.

As carboxylic acid, a compound having at least one carboxyl group can be broadly used, and for example, formic acid, oxalic acid, acetic acid, hexane acid, acrylic acid, octylic acid, oleic acid and the like are exemplified. A carboxyl group in a part of carboxylic acid may form salt with metallic ion. Furthermore, for the metallic ion, two or more types of metallic ions may be included.

The carboxylic acid may be a compound containing a functional group other than a carboxyl group, such as an amino group, a hydroxyl group, an alkoxy group, a carbonyl group, an ester group or a mercapto group. In this case, the number of carboxyl groups is preferably more than the number of functional groups other than carboxyl groups. Further, the carboxylic acid may be independently used, respectively, or two or more may be combined. In addition, it is preferable that a boiling point at room temperature is 300 °C or less, is further preferable at 250 °C or less.

The content of the organic substance in the metallic colloid in the composition for bonding of the present embodiment is preferably 0.5 % to 50 % by mass. If the content of the organic substance is 0.5 % by mass or greater, the storage stability of the obtained composition for bonding tends to be better, and if it is 50 % by mass or less, the conductivity of the composition for bonding tends to be better. The more preferable content of the organic substance is 1 % to 30 % by mass, and the further preferable content is 3 % to 15 % by mass.

As a composition ratio (mass) in the case of combining amine and carboxylic acid, it can be optionally selected within the range of 1/99 to 99/1, and it is preferably 10/90 to 90/10 and it is further preferably 20/80 to 80/20. Furthermore, for amine or carboxylic acid, several types of amines or carboxylic acids may be used, respectively.

(1-3) Other components

In the composition for bonding of the present embodiment, in addition to the components above, within the scope that does not impair the effect of the present invention in order to add functions, such as appropriate viscosity, adhesiveness, a drying characteristics or printability, according to a use purpose, optional ingredients, such as a dispersion medium, for example, an oligomer ingredient that fulfills a role as a binder, a resin ingredient, an organic solvent (a portion of solid may be dissolved or dispersed), a surfactant, a thickener or a surface tension adjuster, may be added. Such optional ingredients are not particularly limited.

As the dispersion medium out of the optional ingredients, various ingredients are usable within the scope that does not impair the effect of the present invention, and for example, hydrocarbon, alcohol and the like are exemplified.

As the carbon hydride, aliphatic hydrocarbon, cyclic hydrocarbon, alicyclic hydrocarbon and the like are exemplified, and they may be singularly used, respectively, and two or more types may be combined.

As the aliphatic hydrocarbon, for example, saturated or unsaturated aliphatic hydrocarbon, such as tetradecane, octadecane, heptamethylnonane, tetramethylpentadecane, hexane, heptan, octane, nonane, decane, tridecane, methylpentane, normal paraffin or isoparaffin, is exemplified.

As the cyclic hydrocarbon, for example, toluene, xylene and the like are exemplified.

In addition, as the alicyclic hydrocarbon, for example, limonene, dipentene, terpinene, nesol, cinene, orange flavor, terpinolene, phellandrene, menthadiene, terebene, dihydrocymene, moslene, isoterpinene, crithmene, kautschin, cajeputen, oilimene, pinene, terebine, menthane, pinane, terpene, cyclohexane and the like are exemplified.

Further, alcohol is a compound containing one or more OH groups in the molecular structure, and aliphatic alcohol, cyclic alcohol and alicyclic alcohol are exemplified, and they can be used singularly, respectively, and two or more types can be combined. Further, a portion of an OH group may be induced by an acetoxy group and the like within a scope not impairing the effect of the present invention.

As the aliphatic alcohol, for example, saturated or unsaturated $C_{6-30}$ aliphatic alcohol, such as heptanol, octanol (such as 1-octanol, 2-octanol or 3-octanol), decanol, (such as 1-decanol), lauryl alcohol, tetradecyl alcohol, cetyl alcohol, 2-ethyl-1-hexanol, octadecyl alcohol, hexadecenol or oleyl alcohol, is exemplified.

As the cyclic alcohol, for example, cresol, eugenol and the like are exemplified.

In addition, as the alicyclic alcohol, for example, cycloalkanol, such as cyclohexanol; terpene alcohol (such as monoterpene alcohol), such as terpineol (including α, β and γ isomers, or any mixture of these) or dihydroterpene; dihydroterpineol; myrtenol, sobrerol, menthol, carveol, perillyl alcohol, pinocarveol, sobrerol, verbenol and the like are exemplified.

The content in the case of containing a dispersion medium in the composition for bonding of the present embodiment should be adjusted according to desired characteristics, such as viscosity, and the content of the dispersion medium in the composition for bonding is preferably 1 % to 30 % by mass. If the content of the dispersion medium is 1 % to 30 % by mass or greater, an effect to adjust the viscosity can be obtained within the range that is easy to use as a composition for bonding. The more preferable content of the dispersion medium is 1 % to 20 % by mass, and further preferable content is 1 % to 15 % by mass.

As a resin component, for example, polyester resin, polyurethane resin, such as blocked polyisocyanate, polyacrylate resin, polyacrylamide resin, polyether resin, melamine resin, terpene resin and the like are exemplified, and these can be used singularly, respectively, and two or more types can be combined.

As the organic solvent, except for the ones exemplified as the dispersion media, for example, methyl alcohol, ethyl alcohol, n-propylalcohol, 2-propyl alcohol, 1,3-propanediol, 1,2-propanediol, 1,4-butanediol, 1,2,6-hexantril, 1-ethoxy-2-propanol, 2-butoxyethanol, ethylene glycol, diethylene glycol, triethylene glycol, polyethylene glycol having weight-average molecular weight within the range of 200 and 1,000, propylene glycol, dipropylene glycol, tripropylene glycol, polypropylene glycol having weight-average molecular weight within the range of 300 and 1,000, N,N-dimethylformamide, dimethylsulfoxide, N-methyl-2-pyrrolidone, N,N-dimethylacetamide, glycerin, acetone and the like are exemplified, and these can be used singularly, respectively, and two or more types can be combined.

As the thickener, for example, clay mineral, such as clay, bentonite or hectorite; emulsion, such as emulsion resin, acrylic emulsion resin, polyurethane emulsion resin or blocked isocyanate; cellulose derivatives, such as methyl cellulose, carboxymethyl cellulose, hydroxyethyl cellulose, hydroxypropyl cellulose, hydroxypropyl methylcellulose; polysaccharide, such as xanthane gum, guar gum and the like are exemplified, and these can be used singularly, respectively, and two or more types can be combined.

A surfactant, which is different from the organic substances above, can be added. In a multicomponent solvent-series metallic colloid dispersion liquid, roughness of coating surface due to a difference in a volatile rate upon drying and bias of solid content are easily biased. These disadvantages are controlled by adding a surfactant into the composition for bonding of the present embodiment, and a composition for bonding that can form uniform a conductive coating can be obtained.

The surfactant that is usable in the present embodiment is not particularly limited, but any of a anionic surfactant, a cationic surfactant and a nonionic surfactant are usable, and for example, alkyl benzene sulfonate, quaternary ammonium salt and the like are exemplified. Since an effect can be obtained with a small additive amount, a fluorochemical surfactant is preferable.

(2) Manufacturing of composition for bonding

Next, in order to manufacture the composition for bonding containing the metallic colloid of the present embodiment, the metallic particles (metallic colloid particles) coated with an organic substance as a primary component are prepared.

Furthermore, adjustment of an amount of the organic substance and the weight reduction rate is not particularly limited, but it is simple to adjust by heating. This can be adjusted by adjusting an amount of an organic substance to be added on the occasion of preparing metallic particles. Washing conditions and the number of washings after the adjustment of the metallic particles can be changed. Further, heating can be conducted with an oven, evaporator or the like. Heating temperature should be within the range of 50 °C to 300 °C, and a heating time should be for several minutes to several hours. Heating may be conducted under reduced pressure. An amount of an organic substance can be adjusted at lower temperature by heating at reduced pressure. In the case of heating under ordinary pressure, it can be heated even in the atmosphere or in the inert atmosphere. In addition, for fine adjustment of an organic substance quantity, amine or carboxylic acid may be added later.

A method for adjustment of the metallic particles coated with the organic substance of the present invention is not particularly limited, and for example, a method to adjust a dispersion liquid containing metallic particles, and next, to wash the dispersion liquid and the like are exemplified. As a process to prepare the dispersion liquid containing metallic particles, for example, as mentioned below, metallic salt (or metallic ions) dissolved into a solvent should be reduced, and as reduction procedures, a procedure based upon a chemical reduction method should be adopted.

In other words, the metallic particles coated with the organic substance above can be prepared by reducing a raw material liquid (a portion of the component is not dissolved but may be dispersed) containing metallic salt of metal constituting metallic particles, an organic substance as a dispersant and a solvent (basically, an organic system, such as toluene, but water may be contained).

Due to this reduction, the metallic colloid particles where an organic substance as a dispersant is adhered onto at least a portion of surfaces of the metallic particles are obtained. These metallic colloid particles can be supplied as the composition for bonding of the present embodiment as is, but a composition for bonding made from a metallic colloid dispersion liquid can be obtained by adding this to a dispersion medium in a process to be described later as occasion arises.

As a starting material in order to obtain metallic particles coated with the organic substance, various known metallic salts or their hydrate can be used, and for example, silver salt, such as silver nitrate, silver sulfate, silver chloride, silver oxide, silver acetate, silver oxalate, silver formate, silver nitrite, silver chlorate or silver sulfide; for example, gold salt, such as chlorauric acid or gold potassium chloride; for example, platinum salt, such as chloroplatinic acid, platinum chloride, platinum oxide or potassium chloroplatinate; palladium salt, such as palladium nitrate, palladium acetate, palladium chloride, palladium oxide or palladium suphate; and the like are exemplified, but as long as it can be dissolved into an appropriate solvent and is reductable, these are not particularly limited. Further, these can be used singularly and a plurality can be combined.

Further, the method to reduce these metallic salts in the raw material liquid is not particularly limited, and for example, a method using a reducing agent, a method for irradiating a light, such as ultraviolet rays, electron beams, ultrasonic waves, thermal energy or the like are exemplified. Among these, from a viewpoint of easy operation, the method of using a reducing agent is preferable.

As the reducing agent, for example, an amine compound, such as dimethylaminoethanol, methyldiethanolamine, triethanolamine, phenidone or hydrazine; for example, a hydrogen compound, such as sodium boron hydride, hydrogen iodide or hydrogen gas; for example, oxide, such as carbon monoxide, sulfurous acid; for example, a low-valent metallic salt, such as ferrous sulfate, ferric oxide, ferric dumarate, ferrous lactate, ferric oxalate, ferric sulfide, tin acetate, tin chloride, tin diphosphate, tin oxalate, tin oxide or tin sulfate; for example, sugar, such as ethylene glycol, glycerin, formaldehyde, hydroquinone, pyrogallol, tannin, tannic acid, salicylic acid or D-glucose; and the like are exemplified, but as long as the substance is dissolved into a dispersion medium and can reduce the metallic salts above, these are not particularly limited. In the case of using the reducing agent above, reduction reaction can be accelerated by adding light and/or heat.

As a specific method for preparing metallic particles coated with an organic substance using the metallic salt, the organic substance, the solvent and the reducing agent, for example, a method to dissolve the metallic salt into an organic solvent (for example, toluene and the like) for preparing a metallic salt solution, and to add an organic substance into the metallic salt solution as a dispersant, and next, to gradually instill the solution where the reducing agent is dissolved and the like are exemplified.

In the dispersion liquid containing the metallic particles coated with the organic substance as the dispersant obtained as mentioned above, other than the metallic particles, counter ions of metallic salt, a residue of a reducing agent and dispersant exist, and electrolyte concentration of the entire liquid tends to be higher. Since a liquid in such condition has high conductivity, coagulation of metallic particles occurs and it tends to become deposited. Alternatively, even if the liquid does not become deposited, if counter ions of metallic salt, a residue of the reducing agent, or an excessive dispersant, which is more than a required amount for dispersion, remains, the conductivity is likely to be deteriorated. Then, the metallic particles coated with an organic substance can be certainly obtained by washing the solution including the metallic particles for removing an excess residue.

As the washing method, for example, a method where steps to statically place the dispersion liquid containing the metallic particles coated with an organic substance for a certain period of time, and to add alcohol (such as methanol) for stirring again after a generated supernatant solution is removed, and to further statically place the mixture for a certain period of time and to remove a generated supernatant solution are repeated several times; a method where centrifugal separation is conducted instead of still standing; a method for desalting by ultra filtration equipment, ion exchange equipment or the like are exemplified. The metallic particles coated with the organic substance of the present embodiment can be obtained by such washing for removing an organic solvent.

Among the present embodiment, the metallic colloid dispersion liquid is obtained by mixing the metallic particles coated with the organic substance obtained as mentioned above and the dispersion medium explained in the embodiment above.

The mixing method for the metallic particles coated with such organic substance and the dispersion medium is not particularly limited, but it can be conducted with a conventionally-known method using an agitator or a stirrer. The mixture is stirred using a means like a spatula, and an appropriate output of ultrasonic homogenizer may be irradiated.

In the case of obtaining the metallic colloid dispersion liquid containing a plurality of metals, the manufacturing method is not particularly limited, and for example, when the metallic colloid dispersion liquid made of silver and other metal(s) is manufactured, in the preparation of the metallic particles coated with the organic substance, a dispersion liquid containing the metallic particles and another dispersion liquid containing other metallic particles are separately manufactured, and they can be mixed after that, and a silver ion solution and other metallic ion solution can be mixed and then reduced.

(3) Joining method

If the bonding composition of the present embodiment is used, high bonding strength can be obtained in the joining of members in association with heating. In other words, a first member to be bonded and a second member to be bonded can be bonded by a bonding composition application process where the bonding composition is applied between the first member to be bonded and the second member to be bonded, and a bonding process where the bonding composition applied between the first member to be bonded and the second member to be bonded is baked at a desired temperature (for example, 300 °C or lower, preferably between 150 °C and 200 °C) for joining. On this occasion, additional pressure can be added, but obtainment of sufficient bonding strength particularly without adding additional pressure is one of the advantages of the present invention. Further, on the occasion of baking, temperature can be increased and decreased in a step-by-step manner. Further, it is also possible to apply a surfactant, a surface activating agent or the like on surfaces of the members to be bonded in advance.

The inventors of the present application, as a result of keen study, discovered that the first member to be bonded and the second member to be bonded can be further certainly bonded (conjugate can be obtained) with high bonding strength if using the bonding composition of the present embodiment above as the bonding composition in the bonding composition application process.

Herein, "application" of the bonding composition of the present embodiment is a concept including both a case of planarly applying and another case of linearly applying (drawing) the bonding composition. It is possible that the configuration of a coating film made of the bonding composition in the state before applying and baking by heating is desired one. Therefore, in the conjugate of the present embodiment after baking by heating, the bonding composition is a concept including both a planar bonding layer and a linear bonding layer, and these planar bonding layer and linear bonding layer may be continuous or discontinuous, or may include a continuous portion and a discontinuous portion.

As the first member to be bonded and the second member to be bonded that are usable in the present embodiment, they should be ones where the bonding composition is applied, and that are baked and bonded by heating, and there is no particular limitation, but members equipped with thermal resistance to the extent of not damaging at temperature upon bonding are preferable.

As materials constituting such members to be bonded, for example, polyester, such as polyamide (PA), polyimide (PI), polyamide imide (PAI), polyethylene terephthalate (PET), polybutylene terephthalate (PBT) or polyethylene naphthalate (PEN); polycarbonate (PC), polyether sulfone (PES), vinyl resin, fluorine resin, liquid crystal polymer, ceramics, glass, metal or the like can be exemplified, but among them, metallic members to be bonded are preferable. The reason why the metallic members to be bonded are preferable is because they excel in thermal resistance, and, they excel in affinity with the bonding composition of the present invention where inorganic particles are metal.

Further, the member to be bonded may be various shapes, such as plate-like or strip-like, and it can be rigid or flexible. Thickness of the substrate can also be arbitrarily selected. For improvement of adherence property or adhesiveness or other purpose, a member where a surface layer is formed or a member where surface treatment, such as hydrophillic treatment, is applied may be used.

In the process to apply the bonding composition onto the members to be bonded, it is possible to use various methods, but as described above, for example, a method can be arbitrarily selected and used among dipping, screen print, a spray technique, a barcode technique, a spin-coating technique, an inkjet technique, a dispenser technique, an application technique by a brush, a casting technique, a flexo technique, a gravure technique and a syringe technique.

The coating film after being applied as mentioned above is baked by heating at, for example, 300 °C or less within the range that does not damage the members to be bonded, and the conjugant of the present embodiment can be obtained. In the present embodiment, as mentioned above, because the bonding composition of the present embodiment is used, the bonding layer having superior adhesiveness with regard to the members to be bonded can be obtained, and strong bonding strength can be further certainly obtained.

In the present embodiment, when the bonding composition contains a binder ingredient, from viewpoints to improve strength of the bonding layer and improvement of bonding strength between the members to be bonded, the binder ingredient is also baked, but depending upon circumstances, a baking condition is controlled and the binder ingredient may be removed all with adjustment of the viscosity of the bonding composition for applying to various printing methods as a primary purpose of the binder ingredient.

The method for baking is not particularly limited, but for example, the members to be bonded can be bonded by baking so as to adjust the temperature of the bonding composition applied or drawn on the members to be bonded, for example, at 300 °C or less, for example, using a conventionally-known oven or the like. The lower limit of the temperature for baking is not necessarily limited, and it is preferable that it is a temperature than can cause bonding of the members to be bonded, and, it is a temperature within the range that does not impair the effect of the present invention. Herein, in the bonding composition after baking above, from a point to obtain greater bonding strength as much as possible, the lesser a residue of the organic substance is, the better, but a portion of the organic substance may remain within the scope that does not impair the effect of the present invention.

Furthermore, the bonding composition of the present invention contains the organic substance, but unlike the conventional one utilizing thermal curing, such as epoxy resin (for example, epoxy conductive adhesive), it does not obtain the bonding strength after baking due to action of the organic substance, but it obtains sufficient bonding strength by fusion of the fused inorganic particles (metallic particles). Consequently, after bonding, even if the bonding composition is placed in a usage environment at a temperature, which is higher than a bonding temperature, and the residual organic substance is deteriorated and decomposed/disappeared, the bonding strength will never be decreased; therefore, it excels in the thermal resistance.

According to the bonding composition of the present embodiment, since bonding having a bonding layer developing high conductivity can be realized even with baking by heating at low temperature, for example, at 150 °C to 200 °C, the members to be bonded, which comparatively have a susceptibility to heat, can be bonded. Further, a baking time is not particularly limited, and it should be a baking time for enabling to bond the members according to the baking temperature.

In the present embodiment, in order to further enhance the adhesiveness with the members to be bonded and the bonding layer, the surface treatment of the members to be bonded may be conducted. As the surface treatment method, for example, a method where dry treatment, such as corona treatment, plasma treatment, UV treatment or electron ray treatment, is conducted; a method where a primer layer and/or a conductive paste receptive layer is established on a substrate in advance; and the like are exemplified.

Thus, the typical embodiments of the present invention were explained, but the present invention shall not be limited to these. For example, in the embodiments above, the metallic colloid dispersion liquid where metallic particles have been adopted as inorganic particles was explained, and for example, inorganic particles, such as tin-doped indium, alumina, barium titanate or iron lithium phosphate, excelling in, for example, conductivity, thermal conductivity, dielectricity, ion conductivity or the like, can also be used.

Hereafter, in examples, the bonding composition of the present invention will be further explained, but the present invention shall not be limited to these examples at all.

**Examples**

<<Example 1>>

Fifteen grams of hexylamine (EP grade manufactured by Tokyo Chemical Industry Co., Ltd.) were added to 200 mL of toluene (special grade, manufactured by Wako Pure Chemical Industries, Ltd.), and the mixture was stirred well using a magnetic stirrer. While stirring, 10 g of silver nitrate (special grade, manufactured by Waco Pure Chemical Industries, Ltd.) was added, and when the silver nitrate was dissolved, 5 g of oleic acid (first grade, manufactured by Waco Pure Chemical Industries, Ltd.) and 10 g of hexanoic acid (special grade, manufactured by Waco Pure Chemical Industries, Ltd.) was sequentially added, and silver nitrate in a toluene solution was prepared.

Into this silver nitrate in a toluene solution, 0.02 g/mL of sodium borohydride prepared by adding 1 g of sodium borohydride (for chemical, manufactured by Waco Pure Chemical Industries, Ltd.) into 50 mL of ion-exchange water was instilled, and stirring was continued for one hour and silver particles were generated. Then, 250 mL of methanol (special grade, manufactured by Waco Pure Chemical Industries, Ltd.) was added, and the silver particles were spun down. In addition, after the silver particles were completely spun down by centrifugal separation, a reaction residue, a solvent contained in a supernatant fluid and the like were removed.

Precipitate (untreated silver particle composition) containing the silver particles that remained after the supernatant fluid was removed was treated by heating under reduced pressure at 60 °C for 45 minutes using an evaporator, and in the silver particle composition, an amount of the organic substance containing hexylamine, oleic acid and hexanoic acid was decreased to an appropriate amount, and the composition for bonding of the present embodiment was obtained.

[Evaluation test 1]

(1) Thermal analysis

For approximately 10 mg of the composition for bonding obtained above, a thermal analysis test was conducted using a thermogravimetry unit manufactured by Rigaku Corporation. Heating was conducted by increasing a temperature from room temperature (25 °C) to 550 °C at 10 °C/min in nitrogen air current, and weight reduction was measured. Then, using a reduction value (nearly equal to a total amount of an organic substance in a composition) from the initial value (room temperature) to 500 °C as a standard, a weight reduction rate reduced up to 200 °C and a weight reduction rate reduced between 200 °C to 300 °C were obtained by calculation.

A case when the weight reduction rate upon heating to 200 °C was 33 % to 69 % was rated as "1", and another case beyond this range was rated as "2". Further, another case when the weight reduction rate upon heating from 200 °C to 300 °C was 24 % to 50 % was rated as "1", and another case beyond this range was rated as "2". Results are shown in Table 1. The weight reduction rates upon heating up 500 °C were also mentioned in Table 1.

(2) Measurement of bonding strength

A small amount of the composition for bonding obtained above was mounted onto an alumina plate (50 mm cubes) having a surface with a gold finish using a die bonder (manufactured by HiSOL, Inc.), and a commercially-available blue LED chip (manufactured by GeneLite, Inc., 600 microns × 600 microns of area of base) was laminated onto it. On that occasion, additional pressure by adding external force was not added.

Then, the obtained laminated body was placed in a circulating hot air oven adjusted at 270 °C, and baking treatment by heating for 10 minutes was conducted under atmospheric atmosphere. After the laminated body was extracted and cooled down, a bonding strength test for whether or not an area of base of a chip could tolerate stress at 5 MPa using Bondtester (manufactured by RHESCA Corporation) was conducted, and a case of tolerance was rated as "1" and another case when peel-off was observed was rated as "2". Results are shown in Table 1. Further, the bonding strength was measured when baking treatment by heating at 190 °C for 60 minutes instead of heating at 270 °C for 10 minutes, and the bonding strength test for whether or not the area of base of the laminated body (chip) could tolerate stress at 2 MPa was conducted, and a case of tolerance was rated as "1" and another case when peel-off was observed was rated as "2".

(3) Particle size (crystallite diameter)

In addition, particle size of the metallic particles contained in the composition for bonding obtained above was measured with a wide-angle X-ray diffraction technique. Using RINT-Ultima III manufactured by Rigaku Corporation, the particle size was measured within the range of 30 ° to 80 ° of 2θ with the diffraction technique. Measured values at approximately 38 ° (111 planes) indicating the maximum strength out of the obtained diffraction spectrum was substituted into a Scherrer formula, and the particle size (to be more precisely, crystallite diameter) was obtained.

<<Example 2>>

Other than the heating treatment where an untreated silver particle composition was placed in an oven at 150 °C for 60 minutes under atmosphere instead of the heating treatment using an evaporator, the composition for bonding was prepared as similar to Example 1, and the thermal analysis and the bonding strength measurement were conducted. Results are shown in Table 1.

<<Example 3>>

Other than adding terpineol (manufactured by Wako Pure Chemical Industries, Ltd.) as a dispersion medium so as to be 10 % by mass after the heat treatment using an evaporator, the composition for bonding was prepared as similar to Example 1, and the thermal analysis and the bonding strength measurement were conducted. Results are shown in Table 1.

<<Example 4>>

Other than changing the heating time on the occasion of heating using an evaporator to 60 minutes, the composition for bonding was prepared as similar to Example 1, and the thermal analysis and the bonding strength measurement were conducted. Results are shown in Table 1.

<<Comparative example 1>>

Other than the heating treatment by placing an untreated silver particle composition in an oven at 150 °C for 15 minutes under atmosphere instead of the heating treatment using an evaporator, the composition for bonding was prepared as similar to Example 1, and the thermal analysis and the bonding strength measurement were conducted. Results are shown in Table 1.

<<Comparative example 2>>

Other than changing the heating temperature and the heating time on the occasion of heating using an evaporator to 80 °C and 30 minutes, respectively, the composition for bonding was prepared as similar to Example 1, and the thermal analysis and the bonding strength measurement were conducted. Results are shown in Table 1.

<<Comparative example 3>>

Other than changing the heating temperature and the heating time on the occasion of heating using an evaporator to 40 °C and 90 minutes, respectively, the composition for bonding was prepared as similar to Example 1, and the thermal analysis and the bonding strength measurement were conducted. Results are shown in Table 1.

<<Comparative example 4>>

Other than changing the amounts of oleic acid and hexanoic acid to one half, respectively, the composition for bonding was prepared as similar to Example 1, and the thermal analysis and the bonding strength measurement were conducted. Results are shown in Table 1.

<<Comparative example 5>>

Other than preparing the composition for bonding merely by completely spinning down the silver particles with centrifugal separation without adjusting an amount of the organic substance by heating treatment thereafter, the composition for bonding was prepared as similar to Example 1, and the thermal analysis and the bonding strength measurement were conducted. Results are shown in Table 1.

<<Comparative example 6>>

Other than without applying heating treatment to an untreated silver particle composition by an evaporator, then, adding a small amount (10 mL) of toluene and dispersing the silver particles again as a washing process, and spinning down the silver particles again, and spinning down the silver particles into 250 mL of methanol, and then, obtaining completely-spun-down silver particles by centrifugal separation; the composition for bonding was prepared as similar to Example 1, and the thermal analysis and the bonding strength measurement were conducted. Results are shown in Table 1.

<<Comparative example 7>>

Other than conducting the washing process in Comparative example 6 above twice, the composition for bonding was prepared as similar to Comparative example 6, and the thermal analysis and the bonding strength measurement were conducted. Results are shown in Table 1.

<<Comparative example 8>>

Other than conducting the washing process in Comparative example 6 three times, the composition for bonding was prepared as similar to Comparative example 6, and the thermal analysis and the bonding strength measurement were conducted. Results are shown in Table 1.

Table 1:

| | | Weight reduction rate up to 200 °C (wt%) | Evaluation | Weight reduction rate between 200 °C and 300 °C (wt%) | Evaluation | Weight reduction rate up to 500 °C (wt%) | Bonding strength with baking at 270 °C | Bonding strength with baking at 190 °C | Particle size (nm) |
|---|---|---|---|---|---|---|---|---|---|
| Example | 1 | 40.1 | 1 | 39.0 | 1 | 8.6 | 1 | 1 | 31 |
| | 2 | 50.2 | 1 | 34.6 | 1 | 9.8 | 1 | 1 | 32 |
| | 3 | 63.2 | 1 | 25.8 | 1 | 15.6 | 1 | 1 | 36 |
| | 4 | 34.1 | 1 | 40.5 | 1 | 9.3 | 1 | 1 | 16 |
| Comparative example | 1 | 28.0 | 2 | 41.5 | 1 | 10.2 | 2 | 2 | 22 |
| | 2 | 34.3 | 1 | 50.5 | 2 | 6.8 | 2 | 2 | 17 |
| | 3 | 69.9 | 2 | 23.1 | 2 | 16.2 | 2 | 2 | 19 |
| | 4 | 82.2 | 2 | 14.3 | 2 | 20.8 | 2 | 2 | 21 |
| | 5 | 81.4 | 2 | 10.3 | 2 | 22.0 | 2 | 2 | 13 |
| | 6 | 71.4 | 2 | 21.3 | 2 | 16.6 | 2 | 2 | 16 |
| | 7 | 71.3 | 2 | 22.3 | 2 | 14.0 | 2 | 2 | 14 |
| | 8 | 70.4 | 2 | 22.2 | 2 | 16.9 | 2 | 2 | 17 |

According to the results shown in Table 1, it has become ascertained that the composition for bonding with 33 % to 69 % of the weight reduction rate upon heating from room temperature to 200 °C according to thermal analysis, and, with 24 % to 50 % of the weight reduction rate upon heating from 200 °C to 300 °C is used and joined, high bonding strength can be obtained. Furthermore, adding for confirmation, even if the baking temperature is, for example, less than 200 °C, an organic substance contained in the weight reduction rate upon heating from 200 °C to 300 °C according to thermal analysis does not all remain, but it is also possible to remove such organic substance according to baking conditions, such as prolonging a baking time. Consequently, as shown in the examples, even if the baking temperature is less than 200 °C, it becomes possible to sufficiently enhance the bonding strength.

<<Example 5>>

Fifty grams of hexylamine (EP grade manufactured by Tokyo Chemical Industry Co., Ltd.) were added to 300 mL of toluene (special grade manufactured by Wako Pure Chemical Industries, Ltd.), and the mixture was stirred well with a magnetic stirrer. While stirring, 10 g of silver nitrate (special grade manufactured by Wako Pure Chemical Industries, Ltd.) was added, and when silver nitrate was dissolved, 10 g and oleic acid (first grade manufactured by Wako Pure Chemical Industries, Ltd.) and 5 g of hexanoic acid (special grade manufactured by Wako Pure Chemical Industries, Ltd.) were sequentially added, and silver nitrate in a toluene solution was prepared.

After this silver nitrate in a toluene solution was sufficiently stirred and heat was removed, 0.02 g/mL of sodium boron hydride solution, which was prepared by adding 2 g of sodium boron hydride (for chemical, manufactured by Wako Pure Chemical Industries, Ltd.) into 100 mL, of ion-change water, was instilled into this silver nitrate in a toluene solution, stirring was continued for one hour and silver particles were generated. After that, 500 mL of methanol (special grade manufactured by Wako Pure Chemical Industries, Ltd.) was added, and silver particles were spun down. In addition, after the silver particles were completely spun down by centrifugal separation, a reaction residue, a solvent and the like contained in the supernatant fluid were removed.

After precipitate (untreated silver particle composition) containing residual silver particles after the supernatant fluid was removed was depressurized for several minutes using a diaphragm pump and a minute amount of residual methanol was evaporated substantially, heating treatment was applied by placing in an oven at 250 °C for 30 minutes under atmosphere, and an amount of the organic substance containing hexylamine, oleic acid and hexanoic acid was reduced to an appropriate amount, and the composition for bonding of the present embodiment was obtained.

[Evaluation test 2]

(1) Thermal analysis

Thermal analysis was conducted with the similar method to that in Evaluation test 1. Results are shown in Table 2.

(2) Measurement of bonding strength

Other than producing a laminated body with the similar method to the measurement of bonding strength in Evaluation test 1 above, and conducting the baking treatment by heating for 120 minutes under atmosphere with placement of the obtained laminated body in a circulating hot air oven adjusted at 200 °C; the bonding strength was measured with the similar method for the measurement of bonding strength in Evaluation test 1. In other words, the bonding strength test for whether or not an area of base of the laminated body could tolerate stress at 5 MPa was conducted, and the case of tolerance was rated as index "1", and the case of observing peel-off was rated as index "2" for evaluation. Further, the bonding strength upon peel-off was divided by an area of base of the laminated body (chip) and it was obtained in MPa. Results are shown in Table 2. Furthermore, herein, the reason why the bonding strength at 200 °C was obtained is because a market and customers' needs are orientated toward a lower temperature of baking conditions from a viewpoint of energy saving.

Furthermore, the bonding strength in the case of conducting the baking treatment by heating at 270 °C for 10 minutes was also measured, and the bonding strength test for whether or not the area of base of the laminated body could tolerate stress at 5 MPA was conducted, and the case of tolerance was rated as "1" and the case of observing peel-off was rated as "2", and result are shown in Table 2.

(3) Particle size (crystallite diameter)

In addition, particle size of metallic particles contained in the composition for bonding obtained as mentioned above was measured with the similar method to the particle measurement in Evaluation test 1 above. Results are shown in Table 2.

<<Example 6>>

Other than the heating treatment by placing an untreated silver particle composition in an oven at 200 °C for 20 minutes under atmosphere, the composition for bonding was prepared as similar to Example 5, and the thermal analysis and the bonding strength measurement were conducted. Results are shown in Table 2.

<<Example 7>>

Other than the heating treatment by placing an untreated silver particle composition in an oven at 250 °C for 10 minutes under atmosphere, the composition for bonding was prepared as similar to Example 5, and the thermal analysis and the bonding strength measurement were conducted. Results are shown in Table 2.

<<Example 8>>

Other than the heating treatment by placing an untreated silver particle composition in an oven at 350 °C for 5 minutes under atmosphere, the composition for bonding was prepared as similar to Example 5, and the thermal analysis and the bonding strength measurement were conducted. Results are shown in Table 2.

<<Comparative example 9>>

Other than the heating treatment by placing an untreated silver particle composition in an oven at 150 °C for 15 minutes under atmosphere instead of the heating treatment using an evaporator, the composition for bonding was prepared as similar to Example 5, and the thermal analysis and the bonding strength measurement were conducted. Results are shown in Table 2.

<<Comparative example 10>>

Other than merely cause substantial evaporation of a minute amount of residual methanol by depressurizing for several minutes using a diaphragm pump, without the adjustment of an amount of organic substance by the heating treatment thereafter; the composition for bonding was prepared as similar to Example 5, and the thermal analysis and the bonding strength measurement were conducted. Results are shown in Table 2.

<<Comparative example 11>>

Other than changing to 20 g of hexylamine and 1.5 g of oleic acid; an untreated silver particle composition was obtained as similar to Example 5, and after that, as similar to Example 6, the composition for bonding was prepared with heating treatment by placing in an oven at 200 °C for 20 minutes under atmosphere, and the thermal analysis and the bonding strength measurement were conducted. Results are shown in Table 2.

<<Comparative example 12>>

Other than changing to 20 g of hexylamine and 2.5 g of oleic acid; an untreated silver particle composition was obtained as similar to Example 5, and after that, as similar to Example 6, the composition for bonding was prepared with heating treatment by placing in an oven at 200 °C for 20 minutes under atmosphere, and the thermal analysis and the bonding strength measurement were conducted. Results are shown in Table 2.

Table 2:

| | | Weight reduction rate up to 200 °C (wt%) | Evaluation | Weight reduction rate between 200 °C and 300 °C (wt%) | Evaluation | Weight reduction rate up to 500 °C (wt%) | Bonding strength with baking at 270 °C | Bonding strength with baking at 200 °C | | Particle size (nm) |
|---|---|---|---|---|---|---|---|---|---|---|
| | | | | | | | | Index | MPa | |
| Example | 5 | 40.5 | 1 | 38.5 | 1 | 11.9 | 1 | 1 | 5.6 | 36 |
| | 6 | 34.8 | 1 | 38.2 | 1 | 12.2 | 1 | 1 | 13.4 | 23 |
| | 7 | 49.2 | 1 | 31.8 | 1 | 14.7 | 1 | 1 | 16.5 | 19 |
| | 8 | 47.6 | 1 | 34.4 | 1 | 13.3 | 1 | 1 | 21.3 | 13 |
| Comparative example | 9 | 50.7 | 1 | 23.3 | 2 | 7.3 | 2 | 2 | 0.0 | 41 |
| | 10 | 90.9 | 2 | 4.9 | 2 | 43.8 | 2 | 2 | 0.0 | 3 |
| | 11 | 38.5 | 1 | 34.9 | 1 | 11.7 | 2 | 2 | 0.0 | 72 |
| | 12 | 48.1 | 1 | 30.9 | 1 | 14.5 | 2 | 2 | 0.0 | 45 |

According to the result shown in Table 2, in the case of bonding using the composition for bonding with 33 % to 69 % of the weight reduction rate upon heating from room temperature to 200 °C, and, with 24 % to 50 % of the weight reduction rate upon heating from 200 °C to 300 °C, and in addition, in the case when the crystallite diameter of the silver particles is 4 nm to 40 nm, it becomes ascertained that high bonding strength can be obtained.

**Claims**

1.   A composition for bonding, comprising: inorganic particles and an organic substance containing amine(s) and carboxylic acid(s) adhered onto at least a portion of surfaces of the inorganic particles, wherein
on performance of a thermal analysis in which 10 mg of the composition is heated from room temperature to 550 °C at 10 °C/min in a nitrogen current, and in which the weight reduction of the 10 mg of the composition from room temperature to 500 °C is taken as a standard, the weight reduction rate relative to the standard is 33 % to 69 % upon heating from room temperature to 200 °C, and the weight reduction rate relative to the standard is 24 % to 50 % upon heating from 200 °C to 300 °C.

2.   The composition for bonding according to claim 1, wherein
the crystallite diameter of the inorganic particles is 4 nm to 40 nm.

3.   The composition for bonding according to claim 1 or 2, wherein
the inorganic particles are at least one type of metallic particles selected from a group constituting gold, silver, copper, nickel, bismuth, tin and platinum group elements.

4.   Use of the composition for bonding according any of claims 1 to 3 for bonding of metallic members to be bonded.

**Patentansprüche**

1.   Zusammensetzung zum Binden, die Folgendes umfasst: anorganische Partikel und eine organische Substanz, die (ein) Amin(e) und (eine) Carbonsäure(n) an zumindest einen Teil der Oberflächen der anorganischen Partikel anhaftend umfasst, wobei

bei der Durchführung einer Thermoanalyse, bei der 10 mg der Zusammensetzung in einem Stickstoffstrom mit 10 °C/min von Raumtemperatur auf 550 °C erhitzt werden und bei der die Gewichtsreduktion der 10 mg der Zusammensetzung von Raumtemperatur auf 500 °C als Standard herangezogen wird, die Gewichtsreduktionsrate beim Erhitzen von Raumtemperatur auf 200 °C auf den Standard bezogen 33 % bis 69 % beträgt und die Gewichtsreduktion beim Erhitzen von 200 °C auf 300 °C auf den Standard bezogen 24 % bis 50 % beträgt.

2. Zusammensetzung zum Binden nach Anspruch 1, wobei
der Kristallitdurchmesser der anorganischen Partikel 4 nm bis 40 nm beträgt.

3. Zusammensetzung zum Binden nach Anspruch 1 oder 2, wobei
die anorganischen Partikel zumindest eine Art von metallischen Partikeln sind, die aus der aus Gold-, Silber-, Kupfer-, Nickel-, Wismut-, Zinn- und Platingruppenelementen bestehenden Gruppe ausgewählt sind.

4. Verwendung der Zusammensetzung zum Binden nach einem der Ansprüche 1 bis 3 zum Binden der zu bindenden metallischen Elemente.

## Revendications

1. Composition de liaison, comprenant : des particules inorganiques et une substance organique contenant une ou plusieurs amine(s) et un ou plusieurs acide(s) carboxylique(s) adhérant sur au moins une partie des surfaces des particules inorganiques, dans laquelle
lors de la conduite d'une analyse thermique dans laquelle 10 mg de la composition sont chauffés de la température ambiante à 550 °C à 10 °C/min dans un courant d'azote, et où la réduction de poids des 10 mg de la composition de la température ambiante à 500 °C est utilisée en tant que référence, le taux de réduction de poids par rapport à la référence est de 33 % à 69 % lors du chauffage de la température ambiante à 200 °C, et le taux de réduction de poids par rapport à la référence est de 24 % à 50 % lors du chauffage de 200 °C à 300 °C.

2. Composition de liaison selon la revendication 1, dans laquelle
le diamètre cristallin des particules inorganiques est de 4 nm à 40 nm.

3. Composition de liaison selon la revendication 1 ou 2, dans laquelle
les particules inorganiques sont d'au moins un type de particules métalliques choisi dans un groupe constitué des éléments du groupe de l'or, de l'argent, du cuivre, du nickel, du bismuth, de l'étain et du platine.

4. Utilisation de la composition de liaison selon l'une quelconque des revendications 1 à 3 pour la liaison d'éléments métalliques à lier.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008063688 A
- JP 2011095244 A
- JP 2006049196 A
- WO 2011007402 A